# EUROPÄISCHE PATENTSCHRIFT

(11) **EP 2 009 522 B1**
(45) Veröffentlichungstag und Bekanntmachung des Hinweises auf die Patenterteilung: **19.05.2010**
(21) Anmeldenummer: 07012467.2
(22) Anmeldetag: 26.06.2007
(51) Int. Cl.: G05B 19/042, H02J 13/00

(54) **Peripheriemodul und Peripheriesystem für ein Automatisierungssystem**
Periphery module and periphery system for an automation system
Module périphérique et système périphérique pour un système d'automatisation

(43) Veröffentlichungstag der Anmeldung: 31.12.2008
(73) Patentinhaber: SIEMENS AKTIENGESELLSCHAFT, 80333 München (DE)
(72) Erfinder: Bräunlich, Michael, 09117 Chemnitz (DE); Dausend, Stefan, 91126 Schwabach (DE)

(56) Entgegenhaltungen:
- EP-A- 0 236 711
- EP-A- 1 493 960
- US-A- 5 708 589

## Beschreibung

Die Erfindung betrifft ein Peripheriemodul für ein Automatisierungssystem sowie ein Peripheriesystem für ein Automatisierungssystem.

In Automatisierungssystemen werden einzelne Peripheriemodule bzw. Peripheriebaugruppen häufig zu so genannten Lastgruppen zusammengefügt. Derartige Lastgruppen werden mit einer Versorgungsspannung über ein Netzteil versorgt. Die Bildung von Lastgruppen, die einzeln und gezielt ab- und angeschaltet werden können, ermöglicht eine hohe Flexibilität bei der Anbindung verschiedener Verbraucher innerhalb des Automatisierungssystems. Zudem kann bei der Bildung von mehreren unabhängig mit einer Versorgungsspannung versorgten Lastgruppe leichter eine Diagnose im Störfall durchgeführt werden. Außerdem sorgt die Bildung von Lastgruppen, die im Rahmen einer Störung gezielt abgeschaltet werden können, für eine möglichst effiziente Umsetzung, beispielsweise einer NOT-AUS-Funktion.

Aus der EP 1 493 960 A2 ist ein Automatisierungssystem ausgestaltet als ein Sicherheitsrelayssystem bekannt. Dieses Automatisierungssystem weist Peripheriemodule auf, wobei die Peripheriemodule über eine "Power unit" mit einer Versorgungsspannung versorgt werden.

In der Regel stehen für die selektive Lastgruppenbildung so genannte Powermodule bzw. Einspeisemodule zur Verfügung. Diese Powermodule versorgen mehrere Peripheriemodule bzw. Baugruppen mit der benötigten Versorgungsspannung, die im Rahmen eines Automatisierungssystems standardmäßig 24 V beträgt. Die Powermodule und die an sie jeweils angeschlossenen Peripheriemodule, die eine gemeinsame Lastgruppe bilden, werden innerhalb des Racks an nacheinander folgende Steckplätze gesteckt. Ein Powermodul mit den nachfolgenden Peripheriemodulen bildet dabei jeweils eine von den anderen Gruppen unabhängige Potentialgruppe. Hierbei werden innerhalb der modularen Peripheriesysteme zur individuellen Lastgruppenbildung in der Regel selbstaufbauende interne Potentialschienen verwendet. Die Potentialschienen dienen zur Spannungsversorgung der zu einer Lastgruppe gehörenden Peripheriemodule. Das Powermodul sorgt außerdem dafür, dass die Potentialschiene der vorherigen Lastgruppe von der Potentialschiene der folgenden Lastgruppe getrennt ist und dass die folgende Lastgruppe ihre Versorgungsspannung ausschließlich über das Powermodul bekommt. Hierbei müssen jedoch zwischen den verschiedenen Peripheriebaugruppen, die über ihre Anschlüsse mit den unterschiedlichen Verbrauchern des Automatisierungssystems datentechnisch verbunden sind, und die somit die eigentlichen Automatisierungsaufgaben erfüllen, immer wieder Powermodule gesteckt werden, welche für eine Stromversorgung sorgen. Hierbei wird einerseits Steckplatz auf dem Rack benötigt, andererseits muss bei der Planung des Automatisierungssystems von Vornherein bedacht werden, wie viele Peripheriemodule eine Lastgruppe bilden sollen. Bei einer späteren Umkonfiguration des Systems ist es dann unter Umständen notwendig, die einzelnen Peripheriebaugruppen aus dem Rack zu entfernen und umzustecken, damit ein neu benötigtes Versorgungsmodul dazwischen gesteckt werden kann.

Die Aufgabe der vorliegenden Erfindung besteht darin, eine flexiblere Versorgung von Peripheriemodulen mit der benötigten Versorgungsspannung zu realisieren.

Die Aufgabe wird gelöst durch ein Peripheriemodul für ein Automatisierungssystem, mit Mitteln zum Empfang einer Versorgungsspannung von einem vorgelagerten Peripheriemodul und zur Weiterleitung der Versorgungsspannung an ein nachgelagertes Peripheriemodul, mit einer Anschlussvorrichtung für die Einspeisung einer Versorgungsspannung von einem Netzteil und mit einer Umschaltvorrichtung zur Unterbrechung der Weiterleitung der Versorgungsspannung an das nachgelagerte Peripheriemodul.

Der Erfindung liegt die Erkenntnis zugrunde, dass durch die Möglichkeit, jedes Peripheriemodul mit einer Anschlussmöglichkeit für eine Versorgungsspannung von einem Netzteil auszustatten und gleichzeitig die Möglichkeit zu schaffen, dass mittels einer Umschaltvorrichtung die Versorgungsspannung, welche in der Regel über die Potentialschienen zwischen den einzelnen Peripheriemodulen übertragen wird, zu unterbrechen, so dass nachfolgende Peripheriemodule von der Versorgungsspannung getrennt sind, eine einfache und flexible Bildung von Lastgruppen ermöglicht werden kann. Die Realisierung erfolgt hierbei beispielsweise einfach, indem jedes Peripheriemodul über so genannte Anschlussklemmen verfügt, über die die Versorgungsspannung von dem Netzteil in das Peripheriemodul eingespeist wird. Die Spannung wird dann über die internen selbstaufbauenden Potentialschienen an alle nachfolgenden Peripheriemodule weitergeleitet, wobei jedes einzelne Peripheriemodul selber wieder über Anschlussklemmen und eine entsprechende Umschaltvorrichtung verfügen kann. Die gewünschte Anzahl der Peripheriemodule für die entsprechende Lastgruppe kann dann vom Betreiber des Automatisierungssystems auf einfache Weise zusammengestellt werden, indem nach der letzten benötigten für die Lastgruppe benötigten Peripheriebaugruppe die Umschaltvorrichtung des nächsten Peripheriemoduls derart eingestellt wird, dass die nachfolgenden Peripheriebaugruppen von der entsprechenden Versorgungsspannung der vorherigen Lastgruppe getrennt werden. Die Baugruppe bzw. das Peripheriemodul, an dem die Umschaltvorrichtung betätigt wird, übernimmt dann, wenn wieder eine Versorgungsspannung über die Klemmen angelegt wird, die Funktion der Versorgungsbaugruppe bzw. des Powermoduls.

Auf diese Art und Weise können spezielle Powermodule bzw. Einspeisemodule eingespart werden. Dies führt zu einem geringeren Platzbedarf auf dem Rack und gleichzeitig zu einer höheren Flexibilität sowohl bei der Planung als auch bei einer nachträglichen Änderung der Lastgruppen. Durch das Betätigen des Umschalters bzw. der Umschaltvorrichtung können einfach weitere Peripheriemodule zu einer Lastgruppe hinzugefügt bzw. von ihr abgetrennt werden. Die Reihe der hintereinander gesteckten Peripheriemodule kann durch das erfindungsgemäße System flexibel, schnell und einfach in beliebig große unterschiedliche Lastgruppen unterteilt werden, indem jeweils andere Peripheriemodule bzw. Baugruppen die Funktion eines Powermoduls übernehmen können und eine flexible Trennung von nachfolgenden Lastgruppen durch die Umschaltung ermöglicht wird. Hierbei wird als Standardspannung von den Netzteilen in der Regel 24V geliefert, wie es für Automatisierungssysteme heutzutage gängiger Standard ist. In Teilbereichen der Automatisierungssysteme sind werden auch andere Versorgungsspannungen als 24V eingesetzt. Verschiedene Versorgungsspannungen können auch innerhalb eines Automatisierungssystems gemischt eingesetzt werden.

Insgesamt ermöglicht die Verwendung der erfindungsgemäßen Peripheriemodule in einem Peripheriesystem eines Automatisierungssystems eine kostengünstige Realisierung einer dezentralen Peripherie eines Automatisierungssystems. Außerdem ist bei dem erfindungsgemäßen Peripheriemodul vorteilhaft, dass eine geringere Zahl verschiedener Komponenten produziert, gelagert und auch bestellt bzw. verwaltet werden müssen.

Im Folgenden wird die Erfindung anhand der Figuren näher beschrieben und erläutert.
- Figur 1: zeigt ein schematisches Abbild eines Peripheriesystems nach dem Stand der Technik.
- Figur 2: zeigt eine schematische Darstellung von Peripheriemodulen mit Anschluss und Umschaltevorrichtung.

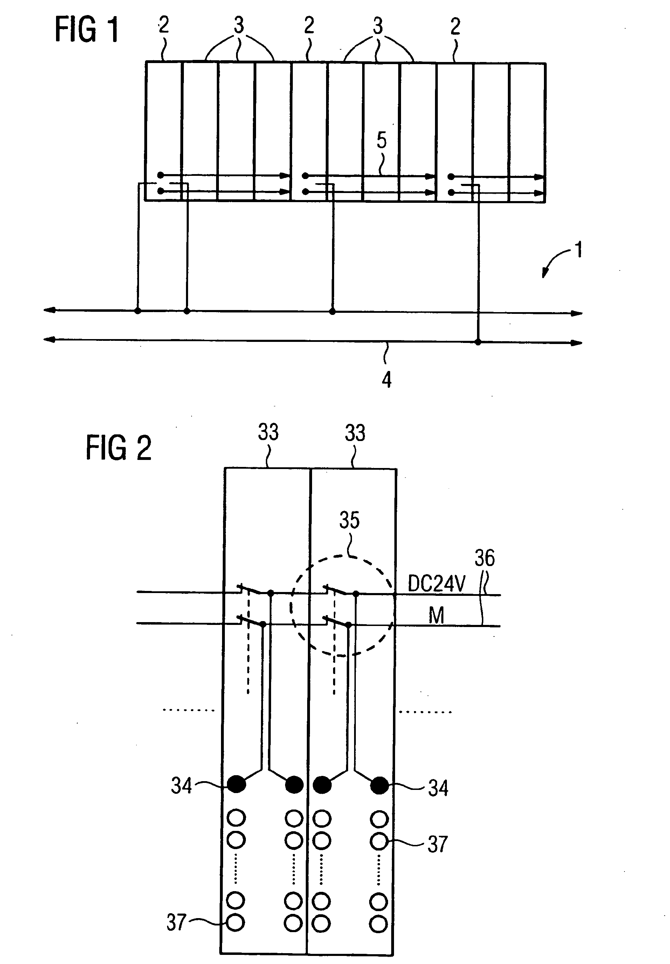

Figur 1 zeigt ein Peripheriesystem 1 innerhalb eines Automatisierungssystems nach dem Stand der Technik. Hier werden über so genannte Einspeise- bzw. Powermodule 2 die einzelnen Peripheriemodule bzw. Peripheriebaugruppen 3 mit der Versorgungsspannung 4 versorgt. Hierbei bilden jeweils ein Einspeisemodul 2 und die auf dem Rack nachfolgenden Peripheriemodule 3 eine so genannte Lastgruppe. Im Falle eines Fehlers werden sie beispielsweise gemeinsam abgeschaltet. Ein neues Einspeisemodul bildet dann jeweils wieder den Anfang einer nächsten Lastgruppe. Die Versorgungsspannung zwischen den einzelnen Peripheriemodulen einer Lastgruppe wird in der Regel über selbstaufbauende interne Potentialschienen 5 realisiert. Hierbei sorgt das Einspeisemodul sowohl für die Versorgung der entsprechenden Lastgruppe mit der notwendigen Versorgungsspannung und zum anderen wird durch das Einspeisemodul auch die Trennung zur jeweilig nächsten Lastgruppe realisiert.

Figur 2 zeigt zwei Peripheriemodule 33 bzw. Peripheriebaugruppen, welche zusätzlich zu den Prozessklemmen 37 über eine Anschlussvorrichtung 34 für die Einspeisung einer Versorgungsspannung von einem Netzteil verfügen. Die Anschlussvorrichtung 34 ist im einfachsten Fall in Form von zwei Anschlussklemmen bzw. Einspeiseklemmen realisiert. Des Weiteren verfügt das Peripheriemodul jeweils über eine Umschaltvorrichtung 35. Die Weiterleitung der Versorgungsspannung zwischen hintereinander gesteckten Peripheriemodulen 33 erfolgt über die Mittel 36 zum Empfang einer Versorgungsspannung von einem vorgelagerten Peripheriemodul und zur Weiterleitung der Versorgungsspannung an ein nachgelagertes Peripheriemodul. Diese sind in der Regel als selbstaufbauende interne Potentialschienen ausgebildet.

Über die Anschlussvorrichtung 34 kann nun eine Versorgungsspannung, beispielsweise von einem Netzteil, an ein Peripheriemodul angelegt werden. Sind die Umschaltvorrichtungen 35 nachgelagerter Peripheriemodule geschlossen, so wird über die selbstaufbauende interne Potentialschiene 36 die Versorgungsspannung an die nachgelagerten Peripheriemodule der jeweiligen Lastgruppe weitergeleitet. Sollen nachfolgende Peripheriemodule 33 von der Lastgruppe getrennt werden, so kann durch einfaches Umlegen der Umschaltvorrichtung 35, beispielsweise durch Öffnen der in Figur 2 gezeigten Schaltet, die Trennung der nachfolgenden Peripheriemodule realisiert werden. Diese bilden dann, wenn das erste Peripheriemodul 33 jeweils wieder eine Versorgungsspannung über die Anschlussvorrichtung 34 erhält, eine neue Lastgruppe. Mittels des Umschalters 35 können somit die Potentialschienen von den links benachbarten Peripheriemodulen getrennt und damit eine neue Potentialgruppe bzw. eine Lastgruppe aufgebaut werden.

Durch die Integration der Funktionalität eines Einspeisemoduls in das normale Peripheriemodul, welches auch als Anschlussklemmenmodul bezeichnet wird, ergibt sich mehrfacher Nutzen. Innerhalb des dezentralen Peripheriesystems wird ein geringerer Platzbedarf durch den Wegfall des Einspeisemoduls bzw. des Powermoduls benötigt. Durch die Möglichkeit, durch einfaches Umlegen der Schalter in der Umschaltvorrichtung 35 ist eine flexible Konfiguration der jeweiligen Lastgruppen möglich. Jedes Peripheriemodul 33 hat die Möglichkeit, funktional die Aufgabe des Einspeisemoduls in einem konventionellen Peripheriesystem zu übernehmen und damit eine Lastgruppe mit der Versorgungsspannung zu versorgen und gleichzeitig eine Trennung von der vorhergehenden Lastgruppe zu ermöglichen. Durch die geringere Anzahl der benötigten Komponenten ist zudem eine kostengünstigere Lagerhaltung möglich.

## Patentansprüche

1. Peripheriemodul (33) für ein Automatisierungssystem,
• mit als selbstaufbauende interne Potentialschienen ausgebildeten Mitteln (36) zum Empfang einer Versorgungsspannung von einem vorgelagerten Peripheriemodul und zur Weiterleitung der Versorgungsspannung an ein nachgelagertes Peripheriemodul,
• mit einer Anschlussvorrichtung (34) für die Einspeisung einer Versorgungsspannung von einem Netzteil und
• mit einer Umschaltvorrichtung (35) zur Unterbrechung der Weiterleitung der Versorgungsspannung an das nachgelagerte Peripheriemodul,
mittels der Umschaltvorrichtung (35) können somit die Potentialschienen von den benachbarten Peripheriemodulen getrennt und damit eine neue Potentialgruppe aufgebaut werden.

2. Peripheriemodul (33) nach einem der vorhergehenden Ansprüche, wobei als Anschlussvorrichtung (34) zwei Einspeiseklemmen für 24V Wechselspannung vorgesehen sind.

3. Peripheriemodul (33)nach einem der vorhergehenden Ansprüche, mit Ein- und Ausgängen zum Empfangen und Senden von Automatisierungsdaten.

4. Verwendung eines Peripheriemoduls (33) nach einem der Ansprüche 1 bis 3 zur Versorgung nachgelagerter Peripheriemodule mit einer Versorgungsspannung, wobei die nachgelagerten Peripheriemodule eine Lastgruppe bilden.

5. Verwendung eines Peripheriemoduls (33) nach einem der Ansprüche 1 bis 4 zur Trennung nachgelagerter Peripheriemodule von der Versorgungsspannung durch Unterbrechung der Weiterleitung der Versorgungsspannung, wobei die nachgelagerten Peripheriemodule eine neue Lastgruppe bilden.

6. Peripheriesystem (1) für ein Automatisierungssystem, mit Peripheriemodulen gemäß einem der Ansprüche 1 bis 3, wobei mindestens ein Peripheriemodul (33) als Versorgungsmodul (2) für die Bereitstellung einer Versorgungsspannung nachgelagerter, eine Lastgruppe bildender Peripheriemodule vorgesehen ist und wobei mindestens ein Peripheriemodul zur Trennung nachgelagerter Peripheriemodule von der Versorgungsspannung durch Unterbrechung der Weiterleitung der Versorgungsspannung vorgesehen ist, wobei die nachgelagerten Peripheriemodule eine neue Lastgruppe bilden.

## Claims

1. Peripheral module (33) for an automation system,
• having means (36), designed as self-constructing internal voltage buses, for receiving a supply voltage from an upstream peripheral module and for relaying the supply voltage to a downstream peripheral module,
• having a connection device (34) for the supply of a supply voltage from a power supply unit and
• having a changeover switching device (35) to interrupt the relaying of the supply voltage to the downstream peripheral module,
by means of the changeover switching device (35) the voltage buses can thereby be disconnected from the adjacent peripheral modules and thus a new potential group can be set up.

2. Peripheral module (33) according to one of the preceding claims, two supply terminals for 24V alternating voltage being provided as a connection device (34).

3. Peripheral module (33) according to one of the preceding claims, with inputs and outputs for receipt and transmission of automation data.

4. Use of a peripheral module (33) according to one of claims 1 to 3 to supply downstream peripheral modules with a supply voltage, the downstream peripheral modules forming one load group.

5. Use of a peripheral module (33) according to one of claims 1 to 4 to disconnect downstream peripheral modules from the supply voltage by interrupting the relaying of the supply voltage, the downstream peripheral modules forming a new load group.

6. Peripheral system (1) for an automation system, having peripheral modules according to one of claims 1 to 3, at least one peripheral module (33) being provided as a supply module (2) for the provision of a supply voltage of downstream peripheral modules forming a load group and at least one peripheral module being provided to disconnect downstream peripheral modules from the supply voltage by interrupting the relaying of the supply voltage, the downstream peripheral modules forming a new load group.

## Revendications

1. Module ( 33 ) périphérique pour un système d'automatisation,
• comprenant des moyens ( 36 ) constitués sous la forme de barres de potentiel internes se formant d'elles-mêmes, pour la réception d'une tension d'alimentation d'un module périphérique en amont et pour l'acheminement de la tension d'alimentation à un module périphérique en aval,
• comprenant un dispositif (34) de connexion, pour l'application d'une tension d'alimentation d'une partie de réseau et
• comprenant un dispositif ( 35 ) de commutation, pour interrompre l'acheminement de la tension d'alimentation au module périphérique en aval,
les barres de potentiel pouvant ainsi, au moyen du dispositif ( 35 ) de commutation, être séparées de modules périphériques voisins et ainsi un nouveau groupe de potentiel pouvant être formé.

2. Module ( 33 ) périphérique suivant l'une des revendications précédentes, dans lequel il est prévu, comme dispositif ( 34 ) de connexion, deux bornes d'alimentation pour une tension alternative de 24 V.

3. Module ( 33 ) périphérique suivant l'une des revendications précédentes, comprenant des entrées et des sorties de réception et d'émission de données d'automatisation.

4. Utilisation d'un module ( 33 ) périphérique suivant l'une des revendications 1 à 3 pour l'alimentation de modules périphériques en aval en une tension d'alimentation, les modules périphériques en aval formant un groupe de charge.

5. Utilisation d'un module ( 33 ) périphérique suivant l'une des revendications 1 à 4 pour séparer des modules périphériques en aval de la tension d'alimentation, par interruption de l'acheminement de la tension d'alimentation, les modules périphériques en aval formant un nouveau groupe de charge.

6. Système ( 1 ) périphérique pour un système d'automatisation ayant des modules périphériques suivant l'une des revendications 1 à 3, dans lequel au moins un module ( 33 ) périphérique est prévu en tant que module ( 2 ) d'alimentation pour la mise d'une tension d'alimentation à disposition d'un module périphérique en aval formant un groupe de charge, dans lequel au moins un module périphérique est prévu pour séparer des modules périphériques en aval de la tension d'alimentation par interruption de l'acheminement de la tension d'alimentation, les modules périphériques en aval formant un nouveau groupe de charge.
